# EUROPEAN PATENT APPLICATION

(11) **EP 4 407 742 A1**
(43) Date of publication of application: **31.07.2024**
(21) Application number: 23192637.9
(22) Date of filing: 22.08.2023
(51) Int. Cl.: H01M 10/42, G01R 31/392, H01M 10/54, H02J 7/00, H01M 10/44, H01M 10/0525

(54) **PROCESSING METHOD, PROCESSING APPARATUS, PROCESSING SYSTEM, AND PROCESSING PROGRAM FOR BATTERY**

(30) Priority: 24.01.2023 JP 2023008741
(71) Applicant: KABUSHIKI KAISHA TOSHIBA, Minato-ku Tokyo 105-0023 (JP)
(72) Inventor: FUKAYA, Taro, Minato-ku Tokyo 105-0023 (JP); KONDO, Asato, Minato-ku Tokyo 105-0023 (JP); YAGI, Ryosuke, Minato-ku Tokyo 105-0023 (JP)
(74) Representative: Hoffmann Eitle

(57) **Abstract**

In an embodiment, in a processing method for a battery, whether a target battery (2) is regenerable without separating an electrode active material serving as a positive electrode active material and an electrode active material serving as a negative electrode active material of the target battery (2) from an electrode group, based on the analysis result of measurement data for the target battery (2).

## Description

### FIELD

Disclosures described herein relate generally to a processing method, a processing apparatus, a processing system and a processing program for battery.

### BACKGROUND

After a battery such as a secondary battery is used in a battery-mounted device such as a vehicle, the used battery is reused or recycled. At this time, whether to reuse or recycle the battery is determined based on the state of the battery including the deteriorated state. For example, a battery having a low degree of deterioration is reused for another battery-mounted device. For a battery having a high degree of deterioration, elements contained in the electrode active material are extracted by, for example, separating the electrode active material from the electrode group and then decomposing the separated electrode active material. Then, the electrode active material is regenerated by synthesizing the extracted elements or the like, and the used battery is recycled.

Depending on the state of the used battery and the like, for example, the positive electrode electric potential and the negative electrode electric potential of the battery may be adjusted to regenerate the battery without separating the electrode active material from the electrode group, whereby the battery may be reusable. For this reason, in the determination on reuse and recycling of the battery, it is required to appropriately determine whether the battery is regenerable without separating the electrode active material from the electrode group. Then, it is required to appropriately determine whether the battery is regenerable without separating the electrode active material from the electrode group so that the battery is effectively made reusable in accordance with the state of the battery.

### BRIEF DESCRIPTION OF DRAWINGS

FIG. 1 is a block diagram schematically illustrating an example of a processing system according to a first approach.
FIG. 2 is a schematic diagram illustrating an internal state parameter indicating an internal state of a battery according to the first approach.
FIG. 3 is a flowchart schematically illustrating an example of a determination process for reuse and recycling of a battery performed by a processing execution unit of a processing apparatus according to the first approach.
FIG. 4 is a flowchart schematically illustrating an example of processing performed by the processing execution unit of the processing apparatus in a case where it is necessary to separate an electrode active material from an electrode group in the example of FIG. 3.
FIG. 5 is a schematic diagram illustrating an example of an estimation result of the internal state of the battery by analysis of measurement data in the first approach.
FIG. 6 is a schematic diagram illustrating an example of an estimation result of the internal state of the battery by the analysis of the measurement data, which is different from the example of FIG. 5, in the first approach.
FIG. 7 is a schematic diagram illustrating an example of an estimation result of the internal state of the battery by the analysis of the measurement data, which is different from the examples of FIGS. 5 and 6, in the first approach.
FIG. 8 is a flowchart schematically illustrating an example of a determination process for reuse and recycling of a battery performed by a processing execution unit of a processing apparatus according to a modification.

### DETAILED DESCRIPTION

According to an approach, in a processing method for a battery, whether a target battery is regenerable without separating an electrode active material serving as a positive electrode active material and an electrode active material serving as a negative electrode active material of the target battery from an electrode group, based on the analysis result of measurement data for the target battery.
approaches will be described below with reference to the drawings.

### (First Approach)

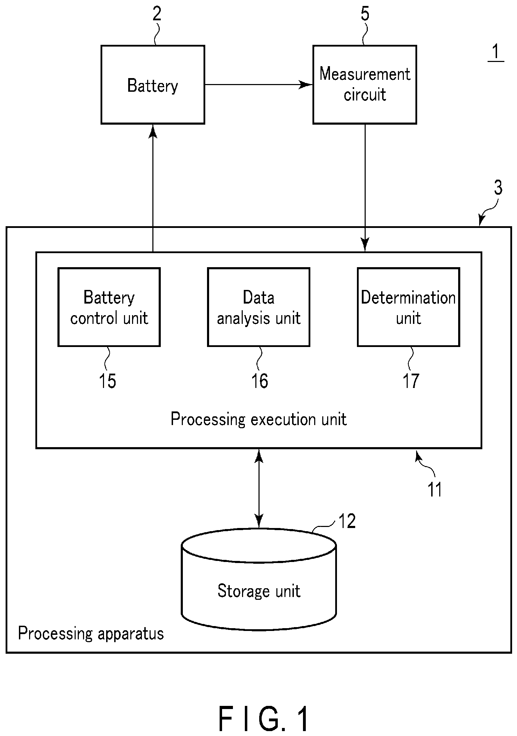

First, a first approach will be described. FIG. 1 illustrates an example of a processing system 1 according to the first approach. As illustrated in FIG. 1, a processing system 1 includes a battery (target battery) 2 to be processed and a processing apparatus 3. The battery 2 is a used battery that has been used in a battery-mounted device, for example. In this case, examples of the battery-mounted device in which the battery 2 has been used include a vehicle, a large power storage apparatus for a power system, a smartphone, a stationary power supply apparatus, a robot, a drone, and the like. The battery 2 is, a secondary battery such as a lithium ion secondary battery, for example. In one example, the battery 2 to be processed is a single cell (single battery) that has been used in a battery-mounted device.

The battery 2 to be a target includes an electrode group, and the electrode group includes a positive electrode and a negative electrode. In the electrode group, a separator is interposed between the positive electrode and the negative electrode. The separator is formed of a material having an electrical insulation property, and electrically insulates the positive electrode from the negative electrode. Examples of the separator include, but are not limited to, a porous film and a nonwoven fabric made of a synthetic resin.

The positive electrode includes a positive electrode current collector such as a positive electrode current collector foil and a positive electrode active material-containing layer supported on a surface of the positive electrode current collector. The positive electrode current collector is an aluminum foil or an aluminum alloy foil with a thickness of about 10 µm to 20 µm, for example, but is not limited thereto. The positive electrode active material-containing layer includes a positive electrode active material, and may optionally contain a binder and an electro-conductive agent. Examples of the positive electrode active material include, but are not limited to, oxides, sulfides, and polymers capable of occluding and releasing lithium ions. The positive electrode active material incudes at least one selected from the group consisting of manganese dioxide, iron oxide, copper oxide, nickel oxide, lithium manganese composite oxide, lithium nickel composite oxide, lithium cobalt composite oxide, lithium nickel cobalt composite oxide, lithium manganese cobalt composite oxide, spinel type lithium manganese nickel composite oxide, lithium phosphorus oxide having an olivine structure, iron sulfate, and vanadium oxide, for example.

The negative electrode includes a negative electrode current collector such as a negative electrode current collector foil and a negative electrode active material-containing layer supported on a surface of the negative electrode current collector. The negative electrode current collector is an aluminum foil, an aluminum alloy foil, or a copper foil with a thickness of about 10 µm to 20 µm, for example, but is not limited thereto. The negative electrode active material-containing layer includes a negative electrode active material, and may optionally contain a binder and an electro-conductive agent. The negative electrode active material is not particularly limited, and examples thereof include metal oxides, metal sulfides, metal nitrides, and carbonaceous materials capable of occluding and releasing lithium ions. Examples of the metal oxide serving as the negative electrode active material include titanium-containing oxides. The titanium-containing oxide to be the negative electrode active material includes a titanium oxide, a lithium titanium-containing composite oxide, a niobium titanium-containing composite oxide, and a sodium niobium titanium-containing composite oxide, for example. Examples of the carbonaceous material to be the negative electrode active material include graphite.

In the electrode group, for example, the positive electrode, the negative electrode, and the separator are wound around a winding axis in a state where the separator is sandwiched between the positive electrode active material-containing layer and the negative electrode active material-containing layer, and the electrode group has a wound structure. In another example, the electrode group has a stack structure in which a plurality of positive electrodes and a plurality of negative electrodes are alternately stacked, and a separator is provided between the positive electrode and the negative electrode.

In the battery 2, the electrode group holds (is impregnated with) an electrolytic solution. The electrolytic solution may be a non-aqueous electrolytic solution in which an electrolyte is dissolved in an organic solvent, or may be an aqueous electrolytic solution such as an aqueous solution in which an electrolyte is dissolved in an aqueous solvent. Instead of an electrolytic solution, a gel electrolyte in which an electrolytic solution and a polymer material are combined may be used. In addition, a solid electrolyte may be used instead of an electrolytic solution or in addition to an electrolytic solution. When a solid electrolyte is used as an electrolyte, the solid electrolyte may be interposed between the positive electrode and the negative electrode instead of the separator in the electrode group. In this case, the positive electrode is electrically insulated from the negative electrode by the solid electrolyte.

In the battery 2, the electrode group is housed inside a container member. As the container member, either a bag-shaped container made of a laminate film or a metal container can be used. As the laminate film, a multilayer film is used, for example, and the multilayer film includes a plurality of resin layers and a metal layer disposed between the resin layers. The metal container is preferably formed of at least one metal selected from the group consisting of aluminum, zinc, titanium, and iron, or an alloy of these metals, for example.

The battery 2 includes a pair of electrode terminals. One of the electrode terminals is a positive electrode terminal that is electrically connected to the positive electrode current collector, and the other of the electrode terminals is a negative electrode terminal that is electrically connected to the negative electrode current collector. The electrode terminal may be an internal terminal formed inside the container member, or may be an external terminal formed on an outer surface of the container member. The electrode terminal is formed of a conductive material, and is preferably formed of at least one metal selected from the group consisting of aluminum, zinc, titanium, and iron, or an alloy of these metals.

In the example of FIG. 1, the processing system 1 includes a measurement circuit 5. The measurement circuit 5 measures (detects) parameters related to the battery 2 to be processed. The parameters related to the battery 2 include a current flowing through the battery 2, a voltage of the battery 2, a temperature of the battery 2, and the like. Therefore, the measurement circuit 5 includes an ammeter that measures current, a voltmeter that measures voltage, a temperature sensor that measures temperature, and the like.

The processing apparatus 3 performs a process such as a determination process on the battery 2 to be processed. The processing apparatus 3 includes a processing execution unit 11 and a storage unit 12. The processing execution unit 11 includes a battery control unit 15, a data analysis unit 16, and a determination unit 17. Each of the battery control unit 15, the data analysis unit 16, and the determination unit 17 performs a part of processing performed by the processing execution unit 11.

The processing apparatus 3 includes a computer such as a server, for example. The processing apparatus 3 includes a processor or an integrated circuit and a storage medium. The processor or the like includes any of a central processing unit (CPU), an application specific integrated circuit (ASIC), a microcomputer, a field programmable gate array (FPGA), a digital signal processor (DSP), and the like. The storage medium (non-transitory storage medium) may be a main storage device such as a memory, or may be an auxiliary storage device. The processing apparatus 3 may include one or more processors or the like and one or more storage media. In the processing apparatus 3, the processor performs processing by executing a program or the like stored in the storage medium or the like. In the processing apparatus 3, the program executed by the processor or the like may be stored in a computer (server) connected via a network such as the Internet, a server in a cloud environment, or the like. In this case, the processor downloads the program via the network. In the processing apparatus 3, processing by the processing execution unit 11 is performed by a processor or the like, and the storage medium functions as the storage unit 12.

In one example, the processing apparatus 3 may include a cloud server in a cloud environment. The infrastructure of the cloud environment includes a virtual processor such as a virtual CPU and a cloud memory. Therefore, in a case where the processing apparatus 3 includes a cloud server, the processing by the processing execution unit 11 is performed by the virtual processor, and the cloud memory functions as the storage unit 12.

In one example, the processing apparatus 3 may be provided with a user interface. In this case, on the user interface, the user or the like of the processing apparatus 3 and the processing system 1 inputs an operation or the like related to the processing for the battery 2. Therefore, the user interface is provided with any of buttons, a mouse, a touch panel, a keyboard, and the like as an operation unit to which an operation is input by the user or the like. The user interface is provided with a notification unit that provides information related to the processing for the battery 2. The notification unit provides information by any of screen display, transmission of sound, and the like. The user interface may be provided separately from the computer or the like constituting the processing apparatus 3.

The processing apparatus 3 performs processing related to reuse and recycling of the battery 2, such as determination of reuse and recycling of the battery 2 to be processed. At this time, the processing execution unit 11 of the processing apparatus 3 measures measurement data to be used for processing. In the measurement of the measurement data, the battery control unit 15 of the processing execution unit 11 charges or discharges the battery 2 under predetermined conditions by controlling charging and discharging of the battery 2. Herein, as predetermined conditions for charging or discharging of the battery 2, a state of charge (SOC) range in charging or discharging, a C rate in charging or discharging, and a temperature in charging or discharging are set, and the battery 2 is charged or discharged under the set predetermined conditions.

In the measurement of the measurement data, the measurement circuit 5 measures the parameters related to the battery 2 in a state where the battery 2 is charged or discharged under the predetermined conditions. Then, the processing execution unit 11 of the processing apparatus 3 acquires results of measurement by the measurement circuit 5 in a state where the battery 2 is charged or discharged under the predetermined conditions. The measurement data measured by the processing execution unit 11 indicates the results of measurement by the measurement circuit 5 in a state where the battery 2 is charged or discharged under the predetermined conditions.

In a state where battery 2 is charged or discharged under the predetermined conditions, the measurement circuit 5 measures the parameters related to the battery 2 at each of the plurality of measurement time points. The measurement data indicates measured values of the parameters related to battery 2 at each of the plurality of measurement time points (the plurality of measurements) and temporal changes (time history) of the parameters related to battery 2 during charging or discharging battery 2 under the predetermined conditions. Therefore, the measurement data indicates the temporal changes (time history) in current of the battery 2, the temporal changes (time history) in voltage of the battery 2, the temporal changes (time history) in temperature of the battery 2, and the like during charging or discharging of the battery 2 under the predetermined conditions.

The processing execution unit 11 or the like of the processing apparatus 3 may calculate temporal changes (time history) of either the charge amount or the SOC of the battery 2 during charging or discharging of the battery 2 under the above-described predetermined conditions, based on the results of measurement of the parameters related to the battery 2 or the like by the measurement circuit 5. In this case, the measurement data indicates the temporal changes (time history) of either the charge amount or the SOC of the battery 2 during charging or discharging of the battery 2 under the predetermined conditions. The measurement data may indicate a relationship between the measured voltage of the battery 2 and either the calculated charge amount or SOC of the battery 2, for example.

Herein, the charge amount (charged amount) of the battery 2 can be calculated based on the charge amount of the battery 2 at the start of charging or discharging under the above-described predetermined conditions and the temporal changes in the current of the battery 2. In this case, the charge amount of the battery 2 is calculated by the current integration method. The charge amount of the battery 2 can also be calculated by a calculation method using a relationship between a voltage between terminals and the charge amount of the battery 2, an estimation method using a Kalman filter, or the like.

In the battery 2, a lower limit voltage Vmin and an upper limit voltage Vmax are defined for the voltage. In the battery 2, for example, a state in which an open circuit voltage (OCV) or the voltage in discharging under a certain specified condition is the lower limit voltage Vmin is defined as a state in which the SOC is 0%, and a state in which the open circuit voltage or the voltage in charging under a certain specified condition is the upper limit voltage Vmax is defined as a state in which the SOC is 100%. In the battery 2, a discharge capacity from the SOC of 100% to the SOC of 0% or a charge capacity from the SOC of 0% to the SOC of 100% is the battery capacity. In the battery 2, the ratio of the residual charge amount until the SOC becomes 0% to the battery capacity is defined as the SOC. Therefore, the SOC of the battery 2 can be calculated based on the charge amount of the battery 2 or the like.

In the example described above, after the battery 2 has been used in the battery-mounted device, the temporal changes in current, voltage, and the like of the battery 2 are measured in a state where the used battery 2 is charged or discharged under the predetermined conditions, but it is not limited thereto. In one example, immediately before the end of use of the battery 2 in the battery-mounted device, or the like, the battery 2 may be charged or discharged under the predetermined conditions, and the temporal changes in current, voltage, and the like of the battery 2 in a state where the battery 2 is charged or discharged under the predetermined conditions may be measured. In this case, measurement data indicating the temporal changes in current, voltage, or the like of the battery 2 in a state of being charged or discharged under the predetermined conditions is stored in a storage medium or the like of the battery-mounted device, and the processing execution unit 11 analyzes the measurement data stored in the storage medium or the like of the battery-mounted device.

In the processing related to reuse and recycling of the battery 2, the data analysis unit 16 of the processing execution unit 11 analyzes the measurement data acquired as described above. Accordingly, the measurement data including measurement results of temporal changes in current and voltage of battery 2 during charging or discharging under the predetermined conditions is analyzed. That is, the processing execution unit 11 performs a charge curve analysis or a discharge curve analysis on the battery 2. The data analysis unit 16 estimates the internal state of the battery 2 based on the analysis results of the charge curve analysis or the discharge curve analysis. The internal state of each of the batteries 2 is indicated by internal state parameters.

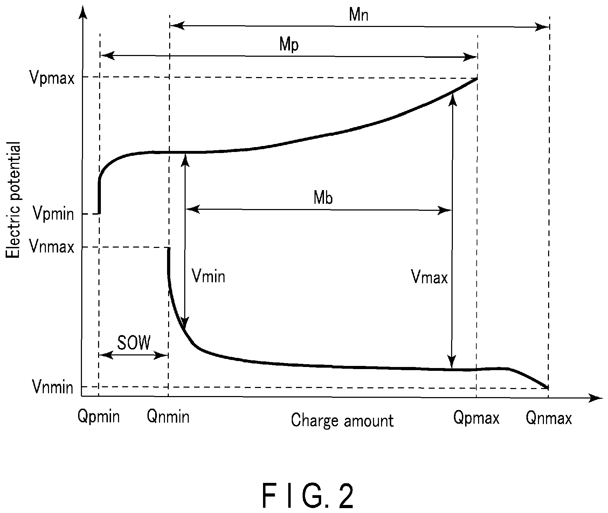

FIG. 2 describes the internal state parameters indicating the internal state of the battery 2. In FIG. 2, the abscissa axis represents the charge amount, and the ordinate axis represents the electric potential. As shown in FIG. 2, in the battery 2, a lower limit electric potential Vpmin and an upper limit electric potential Vpmax are defined for the positive electrode electric potential, and the positive electrode electric potential becomes higher as the charge amount of the positive electrode increases. In the positive electrode, the charge amount in a state where the positive electrode electric potential is the lower limit electric potential Vpmin refers to an initial charge amount (initial charged amount) Qpmin of the positive electrode, and the charge amount in a state where the positive electrode electric potential is an upper limit electric potential Vpmax refers to an upper-limit charge amount (upper-limit charged amount) Qpmax of the positive electrode. In the battery 2, the charged charge amount of the positive electrode from the initial charge amount Qpmin to the upper-limit charge amount Qpmax refers to a positive electrode capacity Mp.

In the battery 2, a lower limit electric potential Vnmin and an upper limit electric potential Vnmax are defined for the negative electrode electric potential, and the negative electrode electric potential becomes lower as the charge amount of the negative electrode increases. In the negative electrode, the charge amount in a state where the negative electrode electric potential is the upper limit electric potential Vnmax refers to an initial charge amount (initial charge amount) Qnmin of the negative electrode, and the charge amount in a state where the negative electrode electric potential is the lower limit electric potential Vnmin refers to an upper-limit charge amount (upper-limit charge amount) Qnmax of the negative electrode. In the battery 2, the charged charge amount of the negative electrode from the initial charge amount Qnmin to the upper limit charge amount Qnmax is the negative electrode capacity Mn.

In the battery 2, the internal state parameters indicating the internal state include the above-described positive electrode capacity Mp, negative electrode capacity Mn, initial charge amount Qpmin of the positive electrode, and initial charge amount Qnmin of the negative electrode. The internal state parameters also include a positive electrode mass which is a parameter corresponding to the positive electrode capacity Mp and a negative electrode mass which is a parameter corresponding to the negative electrode capacity Mn. The positive electrode mass can be calculated based on the positive electrode capacity Mp and the type of material forming the positive electrode in the battery 2 including the type of positive electrode active material. Similarly, the negative electrode mass can be calculated based on the negative electrode capacity Mn and the type of material forming the negative electrode in the battery 2 including the type of negative electrode active material. The internal state parameter of the battery 2 includes a positive electrode capacity retention ratio, a negative electrode capacity retention ratio, and the like. The positive electrode capacity retention ratio is a ratio of the estimated positive electrode capacity to the positive electrode capacity at the start of use of the battery 2, and the negative electrode capacity retention ratio of the battery 2 is a ratio of the estimated negative electrode capacity to the negative electrode capacity at the start of use of the battery 2.

The internal state parameters of the battery 2 also include a shift of operation window (SOW) which is a gap between the initial charge amount Qpmin of the positive electrode and the initial charge amount Qnmin of the negative electrode. The internal state parameters also include parameters related to the internal resistance of battery 2. The parameters related to the internal resistance may include, in addition to the internal resistance in the entire battery 2, resistance in each of the positive electrode and the negative electrode, movement resistance of ions in the electrolyte (electrolytic solution), and the like. The parameters related to the internal resistance may also include an ohmic resistance, a reaction resistance, and a diffusion resistance. FIG. 2 also shows a battery capacity Mb, which is one of battery characteristics of battery 2. As described above, the battery capacity Mb corresponds to the amount of charge until the voltage of the battery 2 (the difference between the positive electrode electric potential and the negative electrode electric potential) reaches the upper-limit voltage Vmax from the lower-limit voltage Vmin.

In the present approach, relational data indicating the relationship between the internal state of the battery 2 and at least one of the current and the voltage of the battery 2 is stored in the storage unit 12. The relational data indicates a calculation formula for calculating at least one of the current and the voltage of the battery 2 from one or more of the internal state parameters of the battery 2 described above, for example. The relationship between the internal state and each of the current and the voltage of battery 2 changes according to the temperature of battery 2 or the like. Therefore, in the relational data, the relationship between the internal state of the battery 2 and at least one of the current and the voltage of the battery 2 may be presented for each of a plurality of different temperatures.

In the charge curve analysis or the discharge curve analysis, the data analysis unit 16 of the processing execution unit 11 performs a fitting calculation (regression calculation), using the measurement results of temporal changes of the current and the voltage of the battery 2 indicated by the measurement data and the above-described relationship data indicating the relationship between the internal state of the battery 2 and the voltage, the current, and the like of the battery 2. At this time, in the calculation formula for calculating at least one of the current and the voltage of the battery 2 from the internal state of the battery 2, the fitting calculation is performed using one or more of the internal state parameters as variables. Then, the data analysis unit 16 calculates one or more internal states as variables such that, for the voltage, the current, and the like of the battery 2, the difference between the measurement value in the measurement data and the calculation value using the calculation formula indicated by the relational data is as small as possible. The internal state of the battery 2 is estimated by calculating the internal state parameters by the fitting calculation as described above.

A method of estimating the internal state of the battery by charge curve analysis or the like is disclosed in Reference Literature 1 (Jpn. Pat. Appln. KOKAI Publication No. 2018-147827) or the like. According to Reference Literature 1, the internal state of a battery is estimated by performing a fitting calculation using measurement data indicating temporal changes in current and voltage of the battery and relational data indicating a relationship between the internal state of the battery and the voltage and current of the battery. In the present approach, the internal state of the battery 2 may be estimated in the same manner as in Reference Literature 1.

In one example, the data analysis unit 16 may estimate the battery characteristics of the battery 2 based on the estimated internal state of the battery 2. The battery characteristics of the battery 2 include an open circuit voltage (OCV), an OCV curve, and the like of the battery 2 in addition to the battery capacity Mb described above. The OCV curve is a function indicating a relationship between a parameter other than the OCV and the OCV, and is a function indicating a relationship between the OCV and the SOC, for example. The internal resistance of the entire battery 2 indicates the internal state of the battery 2 as described above, and also indicates the battery characteristics of the battery 2. Reference Literature 1 describes a method for estimating the battery characteristics of a battery based on the internal state of the battery. In the present approach and the like, the battery characteristics of the battery 2 may be estimated in the same manner as in Reference Literature 1.

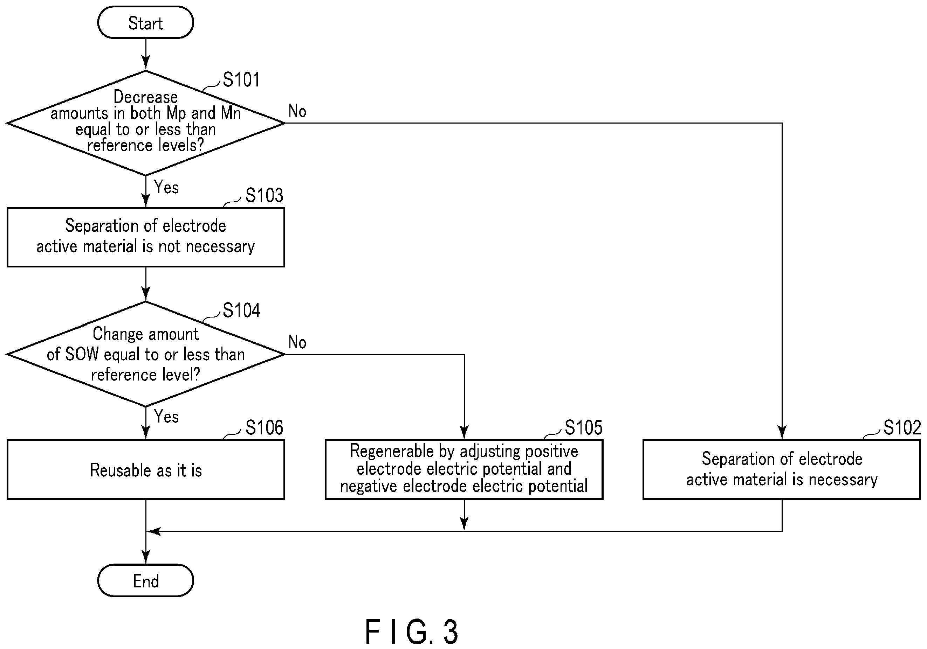

The determination unit 17 of the processing execution unit 11 determines whether the battery 2 is to be reused and recycled based on the analysis results of the measurement data including the estimation result of the internal state of the battery 2. The determination described below is performed by the processing execution unit 11 executing a processing program stored in the storage unit 12, for example. FIG. 3 is a flowchart illustrating an example of a determination process in regard to the reuse and recycling of the battery 2 performed by the processing execution unit 11. The determination process in the example of FIG. 3 is performed on at least the battery 2 whose internal state has been estimated by analysis of the measurement data.

When the process of the example of FIG. 3 is started, the determination unit 17 determines whether the amounts of decrease in both the estimated positive electrode capacity Mp and negative electrode capacity Mn from the start of use of the battery 2 or the like are suppressed to reference levels or less (S101). The reference level for the decrease in the positive electrode capacity Mp is set based on the type of the positive electrode active material, and the reference level for the decrease in the negative electrode capacity Mn is set based on the type of the negative electrode active material.

If the amount of decrease in at least one of the positive electrode capacity Mp and the negative electrode capacity Mn exceeds the reference level (S101-No), the determination unit 17 determines that it is necessary to separate the electrode active material serving as the positive electrode active material and the electrode active material serving as the negative electrode active material from the electrode group (S102). On the other hand, if the amounts of decrease in both the positive electrode capacity Mp and the negative electrode capacity Mn are equal to or less than the reference levels (S101-Yes), the determination unit 17 determines that it is unnecessary to separate the electrode active material serving as the positive electrode active material and the electrode active material serving as the negative electrode active material from the electrode group (S103).

In the example of FIG. 3, if the separation of the electrode active material from the electrode group is unnecessary, the determination unit 17 determines whether the amount of change in the estimated SOW from the start of use of the battery 2 or the like is suppressed to a reference level or less (S104). If the amount of change in the SOW exceeds the reference level (S104-No), the determination unit 17 determines that the battery 2 is regenerable by adjusting the positive electrode electric potential and the negative electrode electric potential (S105). On the other hand, if the amount of change in the SOW is suppressed to the reference level or less (S104-Yes), the determination unit 17 determines that battery 2 is reusable as it is (S106).

When the process of the example of FIG. 3 is performed, the battery 2 in which the amounts of decrease in both the positive electrode capacity Mp and the negative electrode capacity Mn are suppressed to the reference levels or less and the amount of change in the SOW is suppressed to the reference level or less is determined to be reusable as it is without being regenerated. Then, the battery 2 in which the amount of change in the SOW exceeds the reference level but the amounts of decrease in both the positive electrode capacity Mp and the negative electrode capacity Mn are suppressed to the reference levels or less, is determined to be regenerable by adjusting the positive electrode electric potential and the negative electrode electric potential without separating the electrode active material from the electrode group. The battery 2 in which the amount of decrease in at least one of the positive electrode capacity Mp and the negative electrode capacity Mn exceeds the reference level is determined as to be non-regenerable in a state where the electrode active material is not separated from the electrode group, and it is determined that it is necessary to separate the electrode active material from the electrode group.

In the example of FIG. 3, the determination unit 17 of the processing execution unit 11 performs S101 to S106 to determine whether the battery 2 is reusable as it is based on the analysis results of the measurement data for the battery (target battery) 2. The determination unit 17 of the processing execution unit 11 then performs S101 to S106 to determine whether the battery 2 that is not reusable as it is regenerable without separating the electrode active material from the electrode group, based on the analysis results of the measurement data. In the example of FIG. 3, in the determination of whether the battery 2 is regenerable without separating the electrode active material from the electrode group, it is determined at least whether the battery 2 is regenerable by adjusting the positive electrode electric potential and the negative electrode electric potential. If the battery 2 is regenerable by adjusting the positive electrode electric potential and the negative electrode electric potential, it is determined that the battery 2 is regenerable without separating the electrode active material from the electrode group.

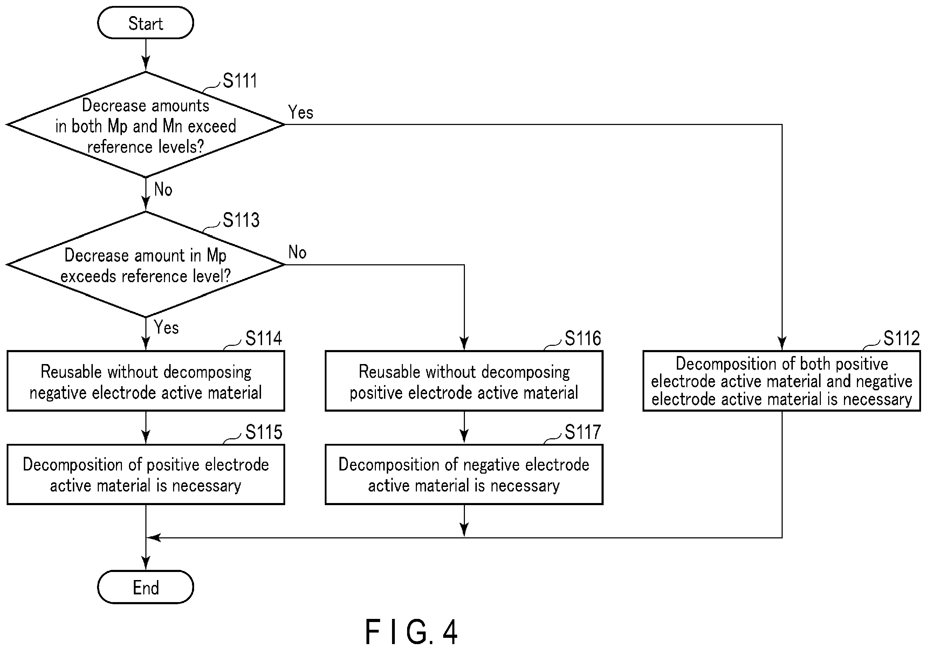

FIG. 4 is a flowchart illustrating an example of a process performed by the processing execution unit 11 if it is necessary to separate the electrode active material from the electrode group in the example of FIG. 3. The process in the example of FIG. 4 is performed by the determination unit 17 only when it is determined that the electrode active material needs to be separated from the electrode group, and is not performed when it is determined that the electrode active material does not need to be separated from the electrode group. That is, the process of the example of FIG. 4 is performed only when it is determined that the battery 2 is not regenerable in a state where the electrode active material is not separated from the electrode group. When the process of the example of FIG. 4 is started, the determination unit 17 of the processing execution unit 11 determines whether the amounts of decrease in both the positive electrode capacity Mp and the negative electrode capacity Mn exceed the above-described reference levels (S111). If the amounts of decrease in both the positive electrode capacity Mp and the negative electrode capacity Mn exceed the reference levels (S111-Yes), the determination unit 17 determines that it is necessary to decompose both the positive electrode active material and the negative electrode active material (S112).

On the other hand, if the amount of decrease in only one of the positive electrode capacity Mp and the negative electrode capacity Mn exceeds the reference level (S111-No), that is, if the amount of decrease in one of the positive electrode capacity Mp and the negative electrode capacity Mn is suppressed to the reference level or less, the determination unit 17 determines whether the amount of decrease in the positive electrode capacity Mp exceeds the reference level (S113). If the amount of decrease in the positive electrode capacity Mp exceeds the reference level (S113-Yes), the determination unit 17 determines that the negative electrode active material is reusable without being decomposed (S114). Then, the determination unit 17 determines that it is necessary to decompose the positive electrode active material (S115). On the other hand, if the amount of decrease in the negative electrode capacity Mn exceeds the reference level (S113-No), the determination unit 17 determines that the positive electrode active material is reusable without being decomposed (S116). Then, the determination unit 17 determines that it is necessary to decompose the negative electrode active material (S117).

By performing S111 to S117 in the example of FIG. 4, the determination unit 17 of the processing execution unit 11 determines whether each of the positive electrode active material and the negative electrode active material as the electrode active materials is reusable without being decomposed, based on the analysis results of the measurement data, for the battery (target battery) 2 determined to be non-regenerable in a state where the electrode active material is not separated from the electrode group. At this time, whether it is necessary to decompose the positive electrode active material is determined based on the positive electrode capacity Mp, and whether it is necessary to decompose the negative electrode active material is determined based on the negative electrode capacity Mn.

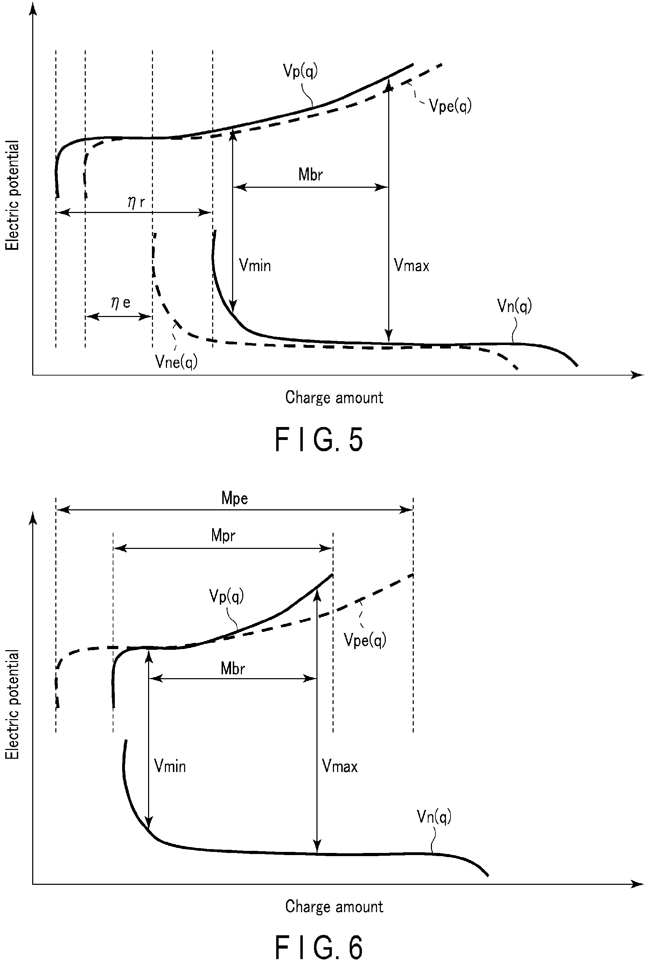

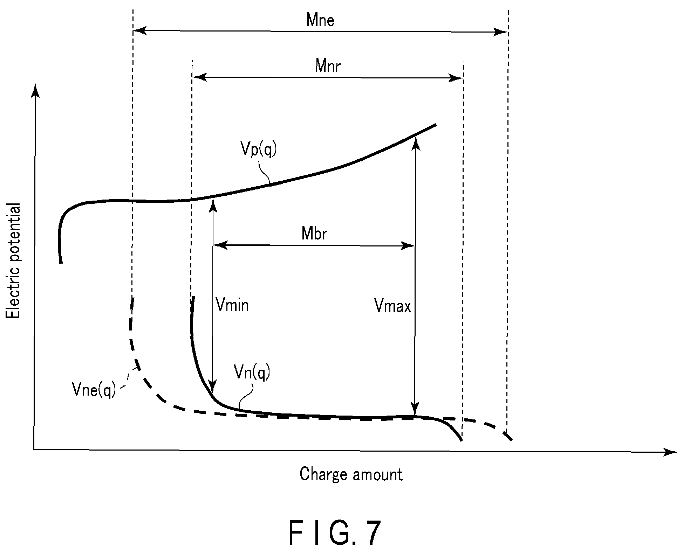

FIG. 5 illustrates an example of the estimation results of the internal state of the battery 2 by the analysis of the measurement data, FIG. 6 illustrates an example of the estimation results of the internal state of the battery 2 by the analysis of the measurement data, which is different from the example of FIG. 5, and FIG. 7 illustrates an example of the estimation results of the internal state of the battery 2 by the analysis of the measurement data, which is different from the examples of FIGS. 5 and 6. In each of Figs. 5 to 7, the abscissa axis represents the charge amount, and the ordinate axis represents the electric potential. In each of Figs. 5 to 7, a relationship Vp(q) between the positive electrode electric potential and the charge amount and a relationship Vn(q) between the negative electrode electric potential and the charge amount are indicated by solid lines as estimation results by analysis of the measurement data. In FIGS. 5 and 6, a relationship Vpe(q) between the positive electrode electric potential and the charge amount at the start of use of the battery 2 is indicated by a broken line, and in FIGS. 5 and 7, a relationship Vne(q) between the negative electrode electric potential and the charge amount at the start of use of the battery 2 is indicated by a broken line.

In the example of FIG. 5, the SOW takes on a value ηe at the start of use of the battery 2, and the SOW takes on a value ηr in the estimation result in real time based on the measurement data, and the amount of change in the SOW from the start of use of the battery 2 exceeds the reference level. Due to the change in SOW from the start of use, the battery capacity Mb of the battery 2 decreases to a value Mbr, which is lower than that at the start of use. However, in the example of FIG. 5, the real-time estimation results of the positive electrode capacity Mp and the negative electrode capacity Mn hardly decrease from the start of use of the battery 2. Therefore, when the internal state of the battery 2 is estimated as in the example of FIG. 5, for example, in the processing of the example of FIG. 3, the determination process is performed in the order of S101-Yes, S103, S104-No, and S105, and it is determined that the battery 2 is regenerable by adjusting the positive electrode electric potential and the negative electrode electric potential without separating the electrode active material from the electrode group. In the example of FIG. 5, the SOW changes from the start of use as the positive electrode electric potential and the negative electrode electric potential are shifted to the high electric potential side with respect to the start of use of the battery 2. In addition, the SOW also changes from the start of use when the positive electrode electric potential and the negative electrode electric potential are shifted to the low electric potential side with respect to the start of use of the battery 2.

In the example of FIG. 6, the positive electrode capacity Mp takes on the value Mpe at the start of use of the battery 2, and the positive electrode capacity Mp takes on the value Mpr in the estimation result in real time based on the measurement data, and the amount of decrease in the positive electrode capacity Mp from the start of use of the battery 2 exceeds the reference level. Due to the decrease in the positive electrode capacity Mp from the start of use, the battery capacity Mb of the battery 2 decreases to the value Mbr, which is lower than that at the start of use. However, in the example of FIG. 6, the estimation result of the negative electrode capacity Mn in real time hardly decreases from the start of use of the battery 2. Therefore, when the internal state of the battery 2 is estimated as in the example of FIG. 6, in the processing of the example of FIG. 3, the determination process is performed in the order of S101-No and S102, for example. Then, in the processing of the example of Fig. 4, the determination process is performed in the order of S111-No, S113-Yes, S114, and S115, for example. As a result, it is determined that the positive electrode active material needs to be decomposed, and it is determined that the negative electrode active material is reusable without being decomposed.

In the example of FIG. 7, the negative electrode capacity Mn takes on the value Mne at the start of use of the battery 2, and the negative electrode capacity Mn takes on the value Mnr in the estimation result in real time based on the measurement data, and the amount of decrease in the negative electrode capacity Mn from the start of use of the battery 2 exceeds the reference level. Due to the decrease in the negative electrode capacity Mn from the start of use, the battery capacity Mb of the battery 2 decreases to the value Mbr, which is lower than that at the start of use. However, in the example of FIG. 7, the estimation result of the positive electrode capacity Mp in real time hardly decreases from the start of use of the battery 2. Therefore, when the internal state of the battery 2 is estimated as in the example of FIG. 7, in the processing of the example of FIG. 3, the determination process is performed in the order of S101-No and S102, for example. Then, in the processing of the example of Fig. 4, the determination processing is performed in the order of S111-No, S113-No, S116, and S117, for example. As a result, it is determined that the negative electrode active material needs to be decomposed, and it is determined that the positive electrode active material is reusable without being decomposed.

In the present approach, if it is determined that the battery 2 is regenerable by adjusting the positive electrode electric potential and the negative electrode electric potential as in S105 of the example of FIG. 3, the battery 2 is regenerated by electric potential adjustment. The battery 2 is regenerated by electric potential adjustment in a state where the electrode active material is not separated from the electrode group. The regeneration of the battery 2 without separating the electrode active material from the electrode group, such as regeneration of the battery 2 by electric potential adjustment, is also called "simple regeneration". In the regeneration of the battery 2 by electric potential adjustment, it is determined whether the positive electrode electric potential and the negative electrode electric potential have shifted to the high electric potential side or the low electric potential side from the start of use of the battery 2 or the like. For example, if the SOW has changed from the start of use as in the example of FIG. 5, it is determined that the positive electrode electric potential and the negative electrode electric potential have shifted to the high electric potential side from the start of use.

If the positive electrode electric potential and the negative electrode electric potential have shifted to the high electric potential side from the start of use, the SOC of the battery 2 is set to a low SOC value such as 10%. The battery 2 is stored for a prescribed period while the SOC of the battery 2 is maintained at a low SOC value. At this time, the battery 2 is stored in a temperature range of 30°C or higher and 50°C or lower, and stored for 3 days, for example, in a state of being maintained at a low SOC value. On the other hand, if the positive electrode electric potential and the negative electrode electric potential have shifted to the low electric potential side from the start of use, the SOC of the battery 2 is set to a high SOC value such as 90%. The battery 2 is stored for a prescribed period while the SOC of the battery 2 is maintained at a high SOC value. At this time, the battery 2 is stored in a temperature range of 30°C or higher and 50°C or lower, and stored for 3 days, for example, in a state of being maintained at a high SOC value.

A method for adjusting the positive electrode electric potential and the negative electrode electric potential of a battery is described in Reference Literature 2 (Jpn. Pat. Appln. KOKAI Publication No. 2021-44161). In the present approach, the battery 2 may be regenerated by adjusting the positive electrode electric potential and the negative electrode electric potential of the battery 2 in the same manner as in Reference Literature 2, without separating the electrode active material from the electrode group.

If it is determined that one of the positive electrode active material and the negative electrode active material is reusable without being decomposed as in S114 and S116 in an example of FIG. 4, a process of reusing the corresponding electrode active material (corresponding one of the positive electrode active material and the negative electrode active material) without being decomposed is performed. The process of reusing the electrode active material without decomposing the electrode active material is also called "direct recycling". In the direct recycling of the electrode active material, a mixture forming an active material-containing layer including the electrode active material is separated from a current collector in the electrode (corresponding one of the positive electrode and the negative electrode) including the electrode active material to be target. When the mixture is separated from the current collector, the target electrode active material is separated from the electrode group. At this time, the mixture containing the electrode active material is separated from the electrode group using an aqueous solvent or the like.

In one example, in direct recycling, a slurry in a state in which a mixture including a target electrode active material, an aqueous solvent, and the like are mixed is reused. At this time, the slurry in a state in which the mixture, the aqueous solvent, and the like are mixed is reused for forming the active material-containing layer in the electrode corresponding to the target electrode active material (corresponding one of the positive electrode and the negative electrode). In another example, the electrode active material is retrieved from a slurry in a state in which a mixture, an aqueous solvent, and the like are mixed. Then, the retrieved electrode active material is reused for formation of the corresponding electrode (corresponding one of the positive electrode and the negative electrode) without being decomposed. However, in any case, the target electrode active material is separated from the electrode group and then reused without being decomposed.

In the direct re-cycling of the electrode active material, after the mixture or the electrode active material is separated from the electrode group, the separated mixture or electrode active material may be subjected to heat treatment such as heating to regenerate the electrode active material. In the direct re-cycling of the electrode active material, before the mixture or the electrode active material is separated from the electrode group, the electrode group or the electrode corresponding to the target electrode active material (corresponding one of the positive electrode and the negative electrode) may be subjected to heat treatment such as heating. Performing the heat treatment before the mixture or the electrode active material is separated from the electrode group allows the mixture to be easily separated from the current collector or the like. The heat treatment performed before the mixture or the electrode active material is separated from the electrode group is preferably performed in a temperature range in which the electrode active material is not deteriorated and the binder is decomposed.

If it is determined that it is necessary to decompose one or both of the positive electrode active material and the negative electrode active material as in S112, S115, and S117 in the example of FIG. 4, a process of decomposing the corresponding electrode active material (corresponding one or both of the positive electrode active material and the negative electrode active material) is performed. At this time, the target electrode active material is decomposed using one or both of dry refining and wet refining. The target electrode active material is decomposed to extract an element included in the electrode active material or a compound or a mixture of elements. Then, the electrode active material is regenerated by synthesizing the extracted (recovered) element or a compound or mixture of elements. The process of extracting an element by decomposition of the electrode active material and synthesizing the extracted element to regenerate the electrode active material is also simply called "recycling". In addition, a process of extracting a compound or a mixture of elements by decomposition of the electrode active material and synthesizing the extracted compound or mixture to regenerate the electrode active material is also called "upcycling".

As described above, in the present approach, it is determined whether the battery 2 to be processed (target battery) is regenerable without separating the electrode active material serving as the positive electrode active material and the electrode active material serving as the negative electrode active material of the battery from the electrode group, based on the analysis results of the measurement data of the battery 2. Therefore, if the battery 2 is regenerable by electric potential adjustment, the battery 2 is regenerable and reusable without separating the electrode active material from the electrode group. As a result, the battery 2 can be effectively reused in accordance with the state of the battery 2, and the battery 2 is reusable in a state of high added value.

In the present approach, in the determination on whether the battery 2 is regenerable without separating the electrode active material from the electrode group, whether the battery 2 is regenerable by adjusting the positive electrode electric potential and the negative electrode electric potential is determined. For this reason, whether the battery 2 is regenerable without separating the electrode active material from the electrode group is appropriately determined based on the internal state of the battery 2 estimated by the analysis of the measurement data and the like.

In the present approach, if it is determined that the battery 2 is not regenerable in a state where the electrode active material is not separated from the electrode group, it is determined whether each of the electrode active materials of the battery 2 is reusable based on the analysis results of the measurement data for the battery 2. Accordingly, if the degree of deterioration of one of the positive electrode active material and the negative electrode active material is large and the degree of deterioration of the other of the positive electrode active material and the negative electrode active material is small, one of the electrode active materials having a small degree of deterioration is reusable without being decomposed. Therefore, the electrode active material of the battery 2 can be effectively reused in accordance with the state of the battery 2, and the electrode active material is reusable in a state of high added value.

For example, if the negative electrode active material is a titanium-containing oxide, the degree of deterioration of the negative electrode active material is small and the negative electrode capacity Mn tends to hardly decrease from the start of use of the battery 2 even though the battery 2 is a used battery or the like that has been used in a battery-mounted device. In the present approach, since the process as described above is performed, the negative electrode active material can be effectively reused in the battery 2 in which the negative electrode active material is a titanium-containing oxide.

In the present approach, it is determined whether the battery 2 is reusable as it is based on the analysis results of the measurement data of the battery 2. Therefore, for the battery 2 in which the electrode active material does not need to be separated from the electrode group, it is appropriately determined whether regeneration such as adjustment of the positive electrode electric potential and the negative electrode electric potential is necessary. Accordingly, the battery 2 can be effectively reused in accordance with the state of the battery 2. For example, in a case where the battery 2 is to be reused in a battery-mounted device different from the battery-mounted device that has been used, such as in a case where the battery 2 having been used in a vehicle is to be reused in a stationary power supply device, it is possible to appropriately determine whether the target battery 2 needs to be regenerated.

### (Modifications)

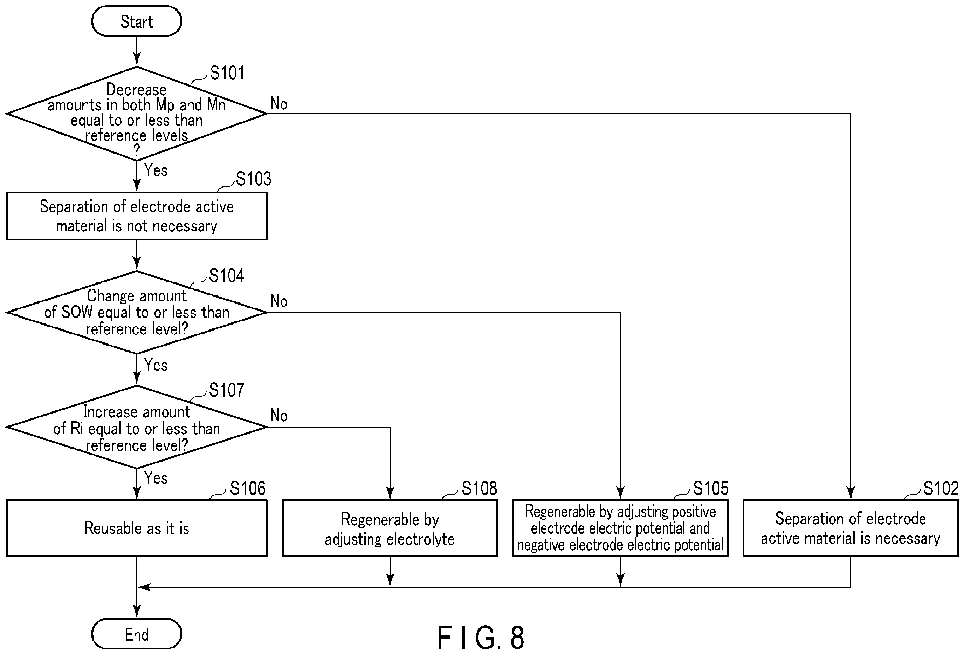

In a modification, as a determination process for reuse and recycling of a battery 2, a process of an example of FIG. 8 is performed by a processing execution unit 11 instead of the process of the example of FIG. 3. Also in the present modification, S101 to S105 are performed as in the example of Fig. 3 and the like. However, in the present modification, when an amount of change in SOW is suppressed to a reference level or less (S104-Yes), the determination unit 17 determines whether the amount of increase in an ion migration resistance Ri of the electrolyte of the battery 2 from the start of use of the battery 2 or the like is suppressed to the reference level or less (S107). As described above, the ion migration resistance Ri of the electrolyte is a parameter related to the internal resistance of the battery 2 and is an internal state parameter indicating the internal state of the battery 2. In addition, the ion migration resistance Ri of the electrolyte is estimated by performing charge curve analysis or discharge curve analysis as described above using measurement data for the battery 2, for example.

In one example, a battery control unit 15 of the processing execution unit 11 inputs AC electric power in which a current value periodically changes to the battery 2 at a plurality of frequencies different from each other. A measurement circuit 5 measures, as measurement data, temporal changes in current and voltage of the battery 2 in a state where the AC electric power is input to battery 2. Then, a data analysis unit 16 or the like of the processing execution unit 11 calculates the impedance of the battery 2 at each of the plurality of frequencies at which the AC electric power was input from the measurement results of the temporal changes in the current and voltage of the battery 2 indicated by the measurement data, and measures the frequency characteristics of the impedance of the battery 2.

In an example of measuring the frequency characteristics of the impedance of the battery 2, an equivalent circuit model of the battery 2 is stored in a storage unit 12. In the equivalent circuit model of the battery 2, circuit parameters are set, and the set circuit parameters (electrical characteristic parameters) include parameters related to the internal resistance of the battery 2 and the ion migration resistance Ri of the electrolyte. In the equivalent circuit model, the relationship between the impedance of the battery 2 and the set circuit parameters is shown, and an arithmetic expression or the like for calculating each of the real component and the imaginary component of the impedance of the battery 2 using the circuit parameters including the ion migration resistance Ri is shown, for example.

In an example of measuring the frequency characteristics of the impedance of the battery 2, the data analysis unit 16 or the like of the processing execution unit 11 performs fitting calculation using the measurement results of the frequency characteristics of the impedance of the battery 2 and the relationship between the impedance of the battery 2 and the circuit parameters indicated by the equivalent circuit model. At this time, the fitting calculation is performed using the circuit parameters including the ion migration resistance Ri of the electrolyte as variables, and circuit parameters to be variables are calculated. In the fitting calculation, the values of the circuit parameters to be variables are determined in a state in which the difference between the calculation result of the impedance using the arithmetic expression represented by the equivalent circuit model and the measurement result of the impedance is as small as possible at each of the plurality of frequencies at which the impedance was measured.

The fitting calculation is performed as described above to calculate the ion migration resistance Ri of the electrolyte set as one of the circuit parameters in the equivalent circuit model. Reference Literature 3 (Jpn. Pat. Appln. KOKAI Publication No. 2017-106889) discloses a method for calculating circuit parameters set in an equivalent circuit model by performing fitting calculation using measurement results of frequency characteristics of impedance of a battery and the equivalent circuit model of the battery. In the present modification, as in Reference Literature 3, the circuit parameters of the equivalent circuit model of the battery 2 may be calculated to estimate the ion migration resistance Ri of the electrolyte.

In the present modification, if the amount of increase in the ion migration resistance Ri is suppressed to the reference level or less (S107-Yes), the determination unit 17 determines that the battery 2 is reusable as it is (S106). On the other hand, if the amount of increase in the ion migration resistance Ri exceeds the reference level (S107-No), the determination unit 17 determines that the battery 2 is regenerable by adjustment of the electrolyte (S108).

Also in the present modification, the determination unit 17 of the processing execution unit 11 then performs S101 to S108 to determine whether the battery 2 that is not reusable as it is regenerable without separating the electrode active material from the electrode group, based on the analysis results of the measurement data. However, in the example of FIG. 8, in the determination on whether the battery 2 is regenerable without separating the electrode active material from the electrode group, whether the battery 2 is regenerable by adjustment of the positive electrode electric potential and the negative electrode electric potential is determined, and whether the battery 2 is regenerable by adjustment of the electrolyte is determined. In each of the case where the battery 2 is regenerable by adjusting the positive electrode electric potential and the negative electrode electric potential and the case where the battery 2 is regenerable by adjusting the electrolyte, it is determined that the battery 2 is regenerable without separating the electrode active material from the electrode group.

In the present modification, if it is determined that the battery 2 is regenerable by the adjustment of the electrolyte as in S108 of the example of FIG. 8, the battery 2 is regenerated by the adjustment of the electrolyte. The regeneration of the battery 2 by the adjustment of the electrolyte is also included in "simple regeneration*"* since the regeneration is performed in a state where the electrode active material is not separated from the electrode group. In the regeneration of the battery 2 using the electrolyte, the battery 2 is regenerated by replenishing or replacing an electrolytic solution to be the electrolyte, for example.

The present modification also achieves the same operations and advantageous effects as those of the first approach and others. That is, also in the present modification, the battery 2 can be effectively reused in accordance with the state of the battery 2, and the battery 2 is reusable in a state of high added value. The electrode active material of the battery 2 can be effectively reused in accordance with the state of the battery 2, and the electrode active material is reusable in a state of high added value.

In the present modification, in the determination of whether the battery 2 is regenerable without separating the electrode active material from the electrode group, whether the battery 2 is regenerable by adjustment of the positive electrode electric potential and the negative electrode electric potential is determined, and whether the battery 2 is regenerable by adjustment of the electrolyte is determined. For this reason, whether the battery 2 is regenerable without separating the electrode active material from the electrode group is further appropriately determined based on the internal state of the battery 2 estimated by the analysis of the measurement data and the like.

In a modification, the same processing as the example of FIG. 8 is performed, and also if the amount of change in a SOW exceeds a reference level in S104 (S104-No), a determination unit 17 determines whether the amount of increase in an ion migration resistance Ri of an electrolyte of a battery 2 from the start of use of the battery 2 or the like is suppressed to a reference level or less as a determination process different from the determination of S107. If the amount of increase in the ion migration resistance Ri is suppressed to be equal to or less than the reference level, the determination unit 17 determines that the battery 2 is regenerable by adjusting the positive electrode electric potential and the negative electrode electric potential as in S105 in the example of FIG. 8.

On the other hand, if the amount of increase in the ion migration resistance Ri exceeds the reference level, the determination unit 17 determines that the battery 2 is regenerable by adjustment of the electrolyte in addition to adjustment of the positive electrode electric potential and the negative electrode electric potential. In this case, the battery 2 is regenerated so as to be reusable by performing both the above-described electric potential adjustment and the above-described electrolyte adjustment. The present modification also achieves the same operations and advantageous effects as those of the modification in FIG. 8 and others.

According to at least one approach or example described above, it is determined whether a target battery is regenerable without separating an electrode active material serving as a positive electrode active material and an electrode active material serving as a negative electrode active material of the target battery from an electrode group, based on the analysis result of measurement data for the target battery. It is possible to provide a processing method, a processing apparatus, a processing system, and a processing program for a battery that enable effective reuse of the battery in accordance with the state of the battery in the determination of reuse and recycling of the battery.

The present disclosure also encompasses the following approaches of a processing method, a processing apparatus, a processing system and a processing program for battery:
1. A processing method for a battery comprising determining whether a target battery (2) is regenerable without separating an electrode active material serving as a positive electrode active material and an electrode active material serving as a negative electrode active material of the target battery (2) from an electrode group, based on analysis result of measurement data for the target battery (2).
2. The processing method according to clause 1, further comprising, if it is determined that the target battery (2) is not regenerable in a state where the electrode active material is not separated from the electrode group, determining whether each of the electrode active material of the target battery (2) is reusable based on the analysis result of the measurement data for the target battery (2).
3. The processing method according to clause 2, further comprising reusing the electrode active material determined to be reusable in the target battery (2) without being decomposed.
4. The processing method according to clause 2 or 3, further comprising extracting an element included in the electrode active material or a compound or a mixture of the element by decomposing the electrode active material determined to be non-reusable in the target battery (2).
5. The processing method according to any one of clauses 1 to 4, further comprising:
   in the determining whether the target battery (2) is regenerable without separating the electrode active material from the electrode group, at least determining whether the target battery (2) is regenerable by adjusting a positive electrode electric potential (Vp) and a negative electrode electric potential (Vn); and
   regenerating the target battery (2) determined to be regenerable by adjusting the positive electrode electric potential (Vp) and the negative electrode electric potential (Vn), by adjusting the positive electrode electric potential (Vp) and the negative electrode electric potential (Vn) in a state where the electrode active material is not separated from the electrode group.
6. The processing method according to clause 5, further comprising:
   in the determining whether the target battery (2) is regenerable without separating the electrode active material from the electrode group, determining whether the target battery is regenerable by adjustment of the positive electrode electric potential (Vp) and the negative electrode electric potential (vn), and determining whether the target battery is regenerable by adjustment of an electrolyte, and
   regenerating the target battery (2) determined to be regenerable by the adjustment of the electrolyte, by adjusting the electrolyte in a state where the electrode active material is not separated from the electrode group.
7. The processing method according to any one of clauses 1 to 6, further comprising:
   determining whether the target battery (2) is reusable as it is based on the analysis result of the measurement data for the target battery (2); and
   reusing the target battery (2) determined to be reusable as it is without separating the electrode active material from the electrode group and regenerating the target battery (2).
8. A processing apparatus (3) for a battery comprising
   a processor configured to determine whether a target battery (2) is regenerable without separating an electrode active material serving as a positive electrode active material and an electrode active material serving as a negative electrode active material of the target battery (2) from an electrode group, based on analysis result of measurement data for the target battery (2).
9. A processing system (1) for a battery, comprising:
   the processing apparatus (3) according to clause 8; and
   the target battery (2) that is determined by the processor of the processing apparatus (3) on whether the target battery (2) is regenerable without separating the electrode active material from the electrode group.
10. The processing system (1) according to clause 9, wherein
   the target battery (2) includes a positive electrode active material and a negative electrode active material, and
   the negative electrode active material includes a titanium-containing oxide.
11. A processing program for a battery, the processing program causing a computer to
   determine whether a target battery (2) is regenerable without separating an electrode active material serving as a positive electrode active material and an electrode active material serving as a negative electrode active material of the target battery (2) from an electrode group, based on analysis result of measurement data for the target battery (2).

While certain approaches have been described, these approaches have been presented by way of example only, and are not intended to limit the scope of the inventions. Indeed, the novel approaches described herein may be embodied in a variety of other forms; furthermore, various omissions, substitutions and changes in the form of the approaches described herein may be made without departing from the spirit of the inventions. The accompanying claims and their equivalents are intended to cover such forms or modifications as would fall within the scope and spirit of the inventions.

## Claims

1. A processing method for a battery comprising determining whether a target battery (2) is regenerable without separating an electrode active material serving as a positive electrode active material and an electrode active material serving as a negative electrode active material of the target battery (2) from an electrode group, based on analysis result of measurement data for the target battery (2).

2. The processing method according to claim 1, further comprising, if it is determined that the target battery (2) is not regenerable in a state where the electrode active material is not separated from the electrode group, determining whether each of the electrode active material of the target battery (2) is reusable based on the analysis result of the measurement data for the target battery (2).

3. The processing method according to claim 2, further comprising reusing the electrode active material determined to be reusable in the target battery (2) without being decomposed.

4. The processing method according to claim 2 or 3, further comprising extracting an element included in the electrode active material or a compound or a mixture of the element by decomposing the electrode active material determined to be non-reusable in the target battery (2).

5. The processing method according to any one of claims 1 to 4, further comprising:
in the determining whether the target battery (2) is regenerable without separating the electrode active material from the electrode group, at least determining whether the target battery (2) is regenerable by adjusting a positive electrode electric potential (Vp) and a negative electrode electric potential (Vn); and
regenerating the target battery (2) determined to be regenerable by adjusting the positive electrode electric potential (Vp) and the negative electrode electric potential (Vn), by adjusting the positive electrode electric potential (Vp) and the negative electrode electric potential (Vn) in a state where the electrode active material is not separated from the electrode group.

6. The processing method according to claim 5, further comprising:
in the determining whether the target battery (2) is regenerable without separating the electrode active material from the electrode group, determining whether the target battery is regenerable by adjustment of the positive electrode electric potential (Vp) and the negative electrode electric potential (vn), and determining whether the target battery is regenerable by adjustment of an electrolyte, and
regenerating the target battery (2) determined to be regenerable by the adjustment of the electrolyte, by adjusting the electrolyte in a state where the electrode active material is not separated from the electrode group.

7. The processing method according to any one of claims 1 to 6, further comprising:
determining whether the target battery (2) is reusable as it is based on the analysis result of the measurement data for the target battery (2); and
reusing the target battery (2) determined to be reusable as it is without separating the electrode active material from the electrode group and regenerating the target battery (2).

8. A processing apparatus (3) for a battery comprising a processor configured to determine whether a target battery (2) is regenerable without separating an electrode active material serving as a positive electrode active material and an electrode active material serving as a negative electrode active material of the target battery (2) from an electrode group, based on analysis result of measurement data for the target battery (2).

9. A processing system (1) for a battery, comprising:
the processing apparatus (3) according to claim 8; and
the target battery (2) that is determined by the processor of the processing apparatus (3) on whether the target battery (2) is regenerable without separating the electrode active material from the electrode group.

10. The processing system (1) according to claim 9, wherein
the target battery (2) includes a positive electrode active material and a negative electrode active material, and
the negative electrode active material includes a titanium-containing oxide.

11. A processing program for a battery, the processing program causing a computer to
determine whether a target battery (2) is regenerable without separating an electrode active material serving as a positive electrode active material and an electrode active material serving as a negative electrode active material of the target battery (2) from an electrode group, based on analysis result of measurement data for the target battery (2).
